# FASCICULE DE BREVET EUROPEEN

(11) **EP 2 372 915 B1**
(45) Date de publication et mention de la délivrance du brevet: **17.04.2013**
(21) Numéro de dépôt: 11160626.5
(22) Date de dépôt: 31.03.2011
(51) Int. Cl.: H03K 17/975, H01H 13/52, H01H 13/85, B60K 37/06, G06F 3/01, H01H 9/20

(54) **Interface homme/machine, en particulier pour véhicule automobile**
Mensch-Maschine-Schnittstelle, insbesondere für ein Fahrzeug
Human machine interface, in particular, for a vehicle

(30) Priorité: 31.03.2010 FR 1052445
(43) Date de publication de la demande: 05.10.2011
(73) Titulaire: VALEO SYSTEMES THERMIQUES, 78320 Le Mesnil Saint-Denis (FR)
(72) Inventeur: AUTRAN, Frédéric, 75018 Paris (FR); EL KHOURY, Ziad, 92160 Antony (FR)
(74) Mandataire: Pothmann, Karsten

(56) Documents cités:
- DE-A1- 3 706 194
- DE-A1-102008 019 124
- US-A- 3 696 908
- US-A1- 2003 169 231

## Description

La présente invention concerne une interface homme/machine.

Bien que non exclusivement, la présente invention s'applique plus particulièrement à une interface homme/machine destinée à réaliser des commandes sur un véhicule automobile. Il peut notamment s'agir de commandes se trouvant au niveau de la console entre les deux sièges avant du véhicule automobile pour, par exemple, commander des fonctions d'une climatisation, d'un système audio, d'un système de téléphonie ou encore d'un système de navigation. L'invention peut également être prévue dans un autre emplacement du véhicule automobile, pour par exemple commander des lumières intérieures, un verrouillage centralisé, un toit ouvrant, ou des feux de détresse. Cette interface homme/machine peut également servir pour des commandes de lève-vitres, de positionnement de rétroviseurs extérieurs ou encore de déplacement de sièges motorisés.

Cette interface homme/machine est du type comportant :
- une surface tactile ; et
- des moyens de commande pour activer une fonction dont une zone dédiée de la surface tactile a été soumise à un contact, ce dernier résultant par exemple de la détection d'un doigt d'un utilisateur sur la surface accessible de la surface tactile.

Une telle interface homme/machine pourvue d'une telle surface tactile présente l'inconvénient, lors de son utilisation, de ne pas fournir de confirmation à un utilisateur pour lui indiquer qu'il a bien activé une fonction.

Pour remédier à cet inconvénient, il est connu d'associer un élément vibrant ou piézoélectrique à la surface tactile permettant de générer une vibration lorsque l'utilisateur appuie sur la zone dédiée. On tente alors de reproduire la sensation produite par l'actionnement d'un bouton en faisant varier la forme et l'intensité des impulsions.

Toutefois, cette solution usuelle présente des inconvénients. En particulier :
- l'effet obtenu par le principe vibratoire n'atteint pas l'objectif requis, en ce sens qu'il n'est pas ressenti par l'utilisateur comme un actionnement d'un bouton ;
- en simulant la sensation d'actionnement d'un bouton par des vibrations, on obtient un résultat qui est difficile à régler et très subjectif, le ressenti des utilisateurs étant extrêmement variable d'un utilisateur à l'autre, certains ressentant une même vibration comme une agression physique alors que d'autres ne sont pas en mesure de la détecter ;
- en essayant de reproduire une sensation largement connue des utilisateurs par un mode d'interaction nouveau, on peut perturber la majorité des utilisateurs qui ne sont pas habitués à ce type d'interaction ; et
- en générant des vibrations, on obtient une solution qui peut être à l'origine :
   · de problèmes d'isolation mécanique par rapport à l'environnement dans lequel l'interface homme-machine est intégré. En effet, une planche de bord d'un véhicule recevant une telle interface est soumise à des vibrations. Pour éviter la transmission de vibrations de la planche vers l'interface, il faut donc prévoir un découplage conséquent et coûteux ;
   · de difficultés de détection par l'utilisateur car les vibrations de l'environnement viennent interférer les vibrations de l'interface en tant que telle, semant ainsi le trouble dans l'esprit de l'utilisateur qui n'est pas en mesure de détecter à quoi correspond la vibration ressentie (en particulier dans une utilisation automobile) ; et
   · de génération de bruits parasites amplifiés par l'environnement de l'interface homme-machine, la planche de bord se comportant alors comme un haut-parleur des vibrations émises par l'interface.

Le document US 3,696,908 A divulgue une structure de bouton poussoir capacitif comprenant un moyen de détection tactile qui est monté de manière à pouvoir être déplacé avec un effet haptique, et des moyens de verrouillage/déverrouillage magnétiques qui, selon la pression exercée sur le bouton poussoir, empêchent ou permettent la poursuite du déplacement du moyen de détection tactile pour l'activation d'un capteur capacitif.

La présente invention concerne une interface homme/machine selon la revendication 1, en particulier pour véhicule automobile, qui permet de remédier aux inconvénients précités.

A cet effet, selon l'invention, l'interface homme/machine comprend :
- un moyen de détection tactile;
- des moyens de translation pour permettre au moyen de détection tactile de se déplacer entre une position proximale et une position distale,
- le déplacement de la position proximale vers la position distale est réalisé sous l'effet d'un appui continu. On entend par appui continu la force constante exercée par l'utilisateur sur le moyen de détection tactile tout au long du déplacement entre la position proximale et la position distale.

Ainsi, grâce à l'invention, lorsqu'un utilisateur appuie sur le moyen de détection tactile pour réaliser une commande tactile l'ensemble de ce moyen de détection tactile se déplace sous l'effet de la pression exercée, ce qui permet à l'utilisateur de savoir que l'interface a pris en compte son actionnement puisque le moyen de détection tactile s'enfonce sous la force d'appui exercée par le doigt de l'utilisateur. Le doigt suit alors le déplacement du moyen de détection tactile jusqu'en butée que l'utilisateur ressent comme l'actionnement effectif de la commande souhaitée.

De plus, cette solution conforme à l'invention ne comprenant pas d'élément vibrant, elle permet de remédier aux inconvénients de la solution usuelle précitée qui simule un actionnement par la génération de vibrations.

Un moyen de commande apte à activer un équipement en réponse à la détection d'un contact tactile sur une zone de sélection du moyen de détection tactile est également prévu dans l'invention. Ce moyen de commande gère les signaux électriques en provenance du moyen de détection tactile et en provenance d'un moyen de commutation faisant parti du système de contrôle. Ce moyen de commande contrôle aussi l'activation des moyens de verrouillage/déverrouillage et l'activation de l'équipement du véhicule.

Selon l'invention, ladite interface homme/machine comporte un système de contrôle qui :
- engendre un effet haptique lors du déplacement du moyen de détection tactile de la position proximale vers la position distale ; et
- détecte ladite position distale, cette détection étant utilisée pour valider la commande de l'équipement qui a été préalablement sélectionnée par le contact tactile sur ladite zone de sélection. Dans un mode de réalisation, ce système de contrôle comprend un premier sous ensemble monostable à actionnement par pression dit moyen cloquant, c'est-à-dire un dispositif possédant une position stable de repos et une position instable dans laquelle il se déforme lorsqu'un effort est appliqué. La déformation du moyen cloquant est proportionnelle à l'effort appliqué, et ceci jusqu'à une transition dudit moyen cloquant. Lors de cette transition, le moyen cloquant se déforme brutalement, ce qui permet la génération d'un effet haptique perceptible par l'utilisateur, D'après l'aspect de l'invention précité, cet effet haptique informe, de plus, l'utilisateur de la réalisation d'une commutation électrique.

Avantageusement, les moyens de translation sont au moins un dispositif de guidage en translation qui prend la forme d'au moins une tige qui se déplace dans un cylindre correspondant. Ce moyen de guidage en translation est complété par un moyen de stabilisation du guidage, ce dernier prenant la forme de deux pantographes placés perpendiculairement l'un par rapport à l'autre.

Selon une variante de l'interface homme/machine, le système de contrôle est agencé dans le prolongement de ladite tige.

Dans cette variante, le système de contrôle comprend un moyen cloquant agencé dans le prolongement de la tige, ledit moyen cloquant exerçant une force pour amener le moyen de détection tactile de sa position distale vers sa position proximale.

Le système de contrôle comprend un moyen de commutation agencé dans le prolongement de la tige et sous le moyen cloquant.

Selon l'invention, l'interface homme-machine comprend des moyens de verrouillage/déverrouillage susceptibles de prendre deux positions, à savoir :
- une position verrouillée de repos, dans laquelle ils empêchent le déplacement du moyen de détection tactile ; et
- une position déverrouillée, dans laquelle ils autorisent ledit déplacement.

Lesdits moyens de verrouillage/déverrouillage sont amenés dans ladite position déverrouillée lors de la détection du contact tactile sur ladite zone de sélection. Ainsi, tant qu'aucun contact tactile n'est réalisé, le moyen de détection tactile est maintenu verrouillé, ce qui empêche notamment un déplacement intempestif.

Ces moyens de verrouillage/déverrouillage sont de type électromagnétique, par exemple une ventouse magnétique. Une telle ventouse n'engendre aucun bruit lors d'une action de vérrouillage/déverrouillage et ne consomment pas d'énergie au repos.

Avantageusement encore, lesdits moyens de verrouillage/déverrouillage sont parallèles ou perpendiculaires audit moyen de détection tactile.

Dans une variante de réalisation de l'interface homme/machine selon l'invention, il est intercalé un support entre le moyen de détection tactile et les moyens de verrouillage/déverrouillage, ces derniers agissant pour verrouiller ou déverrouiller le support.

En complément, il est prévu un dispositif d'affichage qui est installé sous le moyen de détection tactile, ce dernier étant transparent.

L'invention vise également un procédé de validation de la commande d'un équipement d'un véhicule automobile comprenant les étapes suivantes :
- on détecte un contact tactile sur un moyen de détection tactile, avantageusement au moyen du dispositif de commande,
- on sélectionne la commande de l'équipement sur le moyen de détection tactile par contact tactile sur une zone de sélection du moyen de détection tactile,
- on déverrouille des moyens de verrouillage/déverrouillage à la détection du contact tactile sur le moyen de détection tactile, préférentiellement sur instruction de moyen de commande,
- on déplace par translation le moyen de détection tactile,
- on commute un signal au moyen d'un système de contrôle,
- on transmet le signal commuté par exemple au moyen de commande et on active l'équipement correspondant à ladite zone de sélection.

Les figures du dessin annexé feront bien comprendre comment l'invention peut être réalisée. Sur ces figures, des références identiques désignent des éléments semblables.

La figure 1 est le schéma synoptique d'une interface homme/machine conforme à l'invention.

La figure 2 montre schématiquement un mode de réalisation particulier d'une interface homme/machine conforme à l'invention.

Les figures 3 et 4 montrent schématiquement une interface pourvue de moyens de guidage particuliers, et représentent des coupes respectivement selon les lignes B-B et A-A des figures 4 et 3.

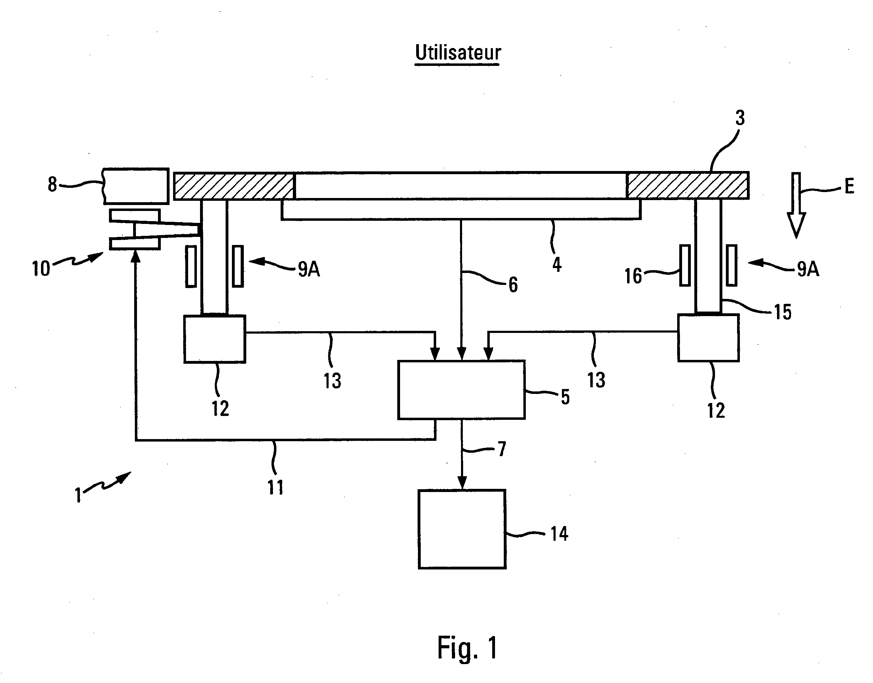

L'interface homme/machine 1 conforme à l'invention et représenté schématiquement sur la figure 1 est destinée à permettre à un utilisateur de commander une pluralité de fonctions d'un équipement d'un véhicule (de préférence d'un véhicule automobile) qui est muni de cette interface 1.

Il peut s'agir de différents types d'équipements. A titre d'illustration sur un véhicule automobile, il peut s'agir notamment de la commande d'une climatisation, d'un système audio, d'un système de téléphonie, d'un système de navigation, de lumières intérieures, d'un verrouillage centralisé, d'un toit ouvrant, de feux de détresse,...

Pour ce faire, ladite interface homme/machine 1 comporte :
- un moyen de détection tactile 4, qui comporte une face supérieure orientée vers l'utilisateur et une face inférieure opposée à la face supérieure et orientée vers l'intérieur d'une planche de bord dudit véhicule. Le moyen de détection tactile 4 est un capteur résistif ou un capteur capacitif. Le moyen de détection tactile 4 est solidarisé à un support 3, ce dernier prenant la forme d'une plaque métallique fine avantageusement en inox. Le moyen de détection 4 est pourvu de zones, appelées zones de sélection, dédiées à des fonctions ou des équipements susceptibles d'être commandés, en particulier telles que celles précitées. Le contact digital sur une zone de sélection appropriée du moyen de détection tactile 4 par un utilisateur permet d'activer la fonction correspondante, qui est par exemple mise en oeuvre par un équipement ou actionneur 14 usuel. Pour des raisons de simplification du dessin, un seul équipement 14 a été représenté sur la figure 1, bien que l'interface homme/machine 1 puisse être associée à une pluralité de tels équipements; et
- des moyens de commande 5, par exemple un calculateur ou un microprocesseur, qui sont reliés par l'intermédiaire d'une liaison électrique 6 audit moyen de détection tactile 4 et qui sont configurés de manière à activer une fonction dont la zone de sélection sur ledit moyen de détection tactile 4 a été soumise à un contact tactile, en envoyant un signal de commande à l'équipement approprié, par exemple à l'équipement 14 via une liaison électrique 7.

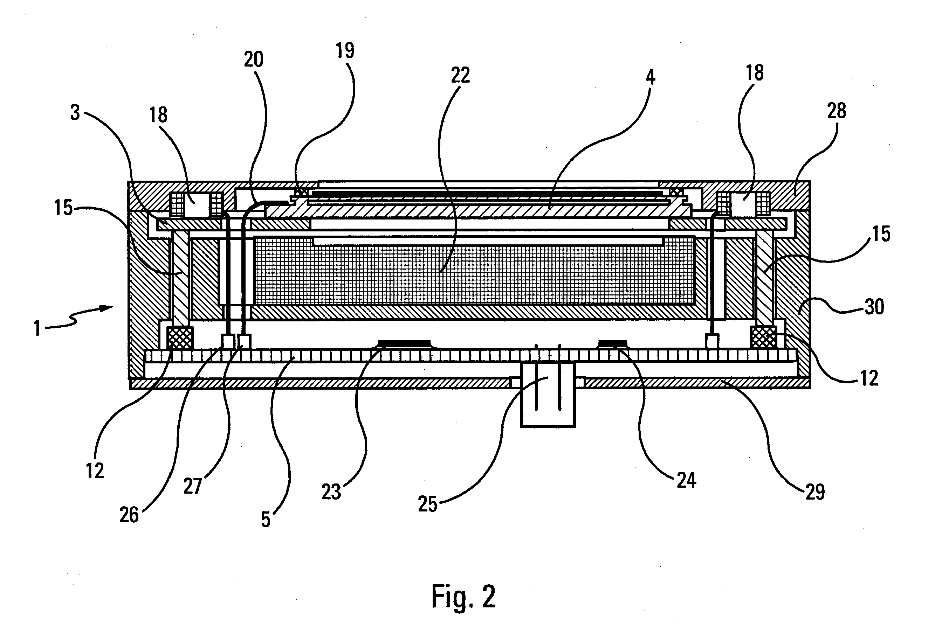

Selon l'invention, L'interface homme-machine 1 comprend des moyens de translation permettant au moyen de détection tactile 4 de se déplacer entre une position proximale, correspondant à la position de repos de l'interface proche de l'utilisateur tel que représentée sur les figures 1 et 2, et une position distale correspondant à une position plus éloignée de l'utilisateur que la position de repos évoquée ci-dessus. Ces moyens de translation prennent la forme d'au moins un dispositif de guidage en translation (référence 9A) du moyen de détection tactile 4, lors du déplacement de ce dernier. Quand le moyen de détection tactile 4 est un parallélépipède rectangle, un moyen de guidage 9A peut être installé à chaque angle du parallélépipède rectangle. Dans ce cas, les moyens de guidage 9A sont au nombre de quatre.

Ledit moyen de détection tactile 4 est monté et fixé sur le support 3 de manière à pouvoir être déplacé dans son ensemble, préférentiellement en translation selon une direction perpendiculaire à la face supérieure du moyen de détection tactile 4 par rapport à un châssis 8. Ce dernier est un composant de l'interface 1, en particulier un boîtier, mais il peut s'agir de la planche de bord du véhicule qui borde directement l'interface homme-machine 1. Le déplacement du moyen de détection tactile 4 est opéré lorsqu'une pression est exercée par un doigt de l'utilisateur sur la face supérieure du moyen de détection tactile 4, en particulier sur la zone de sélection dudit moyen. Dans ce cas, ledit moyen de détection tactile 4 et avantageusement le support 3 sont déplacés dans la direction définie ci-dessus et dans le sens défini par la pression exercée, comme illustré par une flèche E sur la figure 1.

Ainsi, grâce à l'invention, lorsqu'un utilisateur appuie sur le moyen de détection tactile 4 pour réaliser et valider une commande tactile, le moyen de détection tactile 4 se déplace sous l'effet de la pression exercée de sorte à valider la sélection opérée par le doigt de l'utilisateur et offrir à l'utilisateur un ressenti connu de ce dernier.

Ladite interface homme/machine 1 comporte, de plus, des moyens de verrouillage/déverrouillage 10 qui sont susceptibles de prendre deux positions, à savoir :
- une position verrouillée de repos, dans laquelle ils empêchent le déplacement du moyen de détection tactile 4 ; et
- une position déverrouillée, dans laquelle ils autorisent le déplacement dudit moyen de détection tactile 4.

De plus, lesdits moyens de verrouillage/déverrouillage 10 sont amenés dans ladite position déverrouillée lorsqu'un contact tactile est détecté sur la ou les zones de sélection du moyen de détection tactile 4. Dans ce cas, les moyens de commande 5, qui sont informés du placement du doigt sur la zone de sélection par le moyen de détection tactile 4 via la liaison électrique 6, envoient un signal de déverrouillage aux moyens de verrouillage/déverrouillage 10 par l'intermédiaire d'une liaison électrique 11.

Ainsi, tant qu'aucun contact tactile n'est réalisé, le moyen de détection tactile 4 est maintenu verrouillé, ce qui empêche notamment un déplacement intempestif du moyen de détection tactile 4.

Les moyens de verrouillage/déverrouillage 10 s'étendent dans une direction générale parallèle à la face supérieure du moyen de détection tactile. Dans ce cas, le moyen de verrouillage/déverrouillage 10 est placé sur le côté du moyen de détection tactile 4, ou du support 3 le cas échéant. Dans une autre alternative, les moyens de verrouillage/déverrouillage 10 s'étendent dans une direction perpendiculaire à la face supérieure du moyen de détection tactile 4. Ils sont par exemple placés sous le support 3 ou le moyen de détection tactile 4.

En outre, ladite interface homme/machine 1 comporte également au moins un, mais de préférence une pluralité de système de contrôle 12 destinée à créer l'effet haptique ainsi qu'à commuter un interrupteur. Le système 12 présente le qualificatif de contrôle car ce système contrôle ou gère le déplacement du moyen de détection tactile 4 en lui imprimant une évolution de force particulière mais il contrôle ou gère aussi la mise en oeuvre de l'équipement par détection électrique de la validation au moyen de l'interrupteur. Dans ce mode de réalisation préféré, le système de contrôle 12 assure donc une double fonction :
- d'une part, il engendre une résistance au déplacement du moyen de détection tactile lors de son actionnement par un utilisateur, ce qui procure à ce dernier une sensation proche de celle produite par l'actionnement d'un bouton poussoir ; et
- d'autre part, il valide une commande d'un équipement qui a été préalablement sélectionnée. De plus, comme cette validation est réalisée lorsque le moyen cloquant du système de contrôle 12 est complètement enfoncé, l'utilisateur sait exactement si et quand la validation est effectuée.

Le système de contrôle 12 comprend deux sous-ensembles : le premier fournit l'effet haptique recherché et le deuxième est un moyen de commutation électrique. Dans une variante, ces deux sous-ensembles forment un seul et même élément unitaire. Dans une autre variante, le premier sous-ensemble est distinct du deuxième sous-ensemble, c'est-à-dire physiquement dissocié. Le premier sous-ensemble est par exemple un moyen cloquant ou membrane cloquante flexible en caoutchouc ou en élastomère et le deuxième sous-ensemble est par exemple un commutateur, un interrupteur ou tout autre moyen d'actionnement monostable électrique.

Le moyen cloquant prend la forme d'un dôme flexible, c'est-à-dire un composant en matériau flexible en forme de verre inversé susceptible de se déformer sous la pression de l'utilisateur, ledit moyen cloquant possédant une position stable de repos et une position instable dans laquelle il se déforme lorsqu'un effort est appliqué. La déformation est proportionnelle à l'effort appliqué, et ceci jusqu'à une transition dudit moyen cloquant Lors de cette transition, le moyen croquant se déforme brutalement, ce qui permet la génération d'un effet haptique détectable par l'utilisateur.

Le deuxième sous ensemble est moyen de commutation qui prend la forme d'un interrupteur électrique monostable ou tout dispositif de détection électrique. De plus, selon l'invention, cet effet haptique informe également l'utilisateur de la réalisation d'une commutation, cette dernière étant réalisée quand le moyen croquant est en bout de course, c'est-à-dire après son effondrement. A ce stade, l'interrupteur est activé détectant ainsi la validation de la commande de l'équipement 14.

Ledit système de contrôle 12 :
- engendre donc un effet haptique lors du déplacement du moyen de détection tactile 4, sous l'action d'une pression exercée par un utilisateur ; et de plus
- détecte ledit déplacement, lorsqu'il est complètement enfoncé, c'est-à-dire en position distale. Cette détection est utilisée pour valider une fonction qui a été préalablement sélectionnée par le contact de la zone de sélection sur le moyen de détection 4. Les moyens de commande 5 envoient alors un signal approprié à l'équipement 14 à commander.

Ledit système 12 assure ainsi une double fonction :
- d'une part, il engendre une résistance au déplacement du moyen de détection tactile 4 lors de son actionnement par l'utilisateur, ce qui procure à ce dernier une sensation reconnaissable de l'utilisateur et proche de celle produite par l'actionnement d'un bouton poussoir ; et
- d'autre part, il commande la validation d'une fonction, qui a été préalablement sélectionnée, par commutation de l'interrupteur disposé sous le moyen cloquant. De plus, comme cette validation est réalisée lorsque ledit système de contrôle 12 est en position distale (complètement enfoncé), l'utilisateur sait exactement si et quand la validation est effectuée.

L'effet haptique, qui se matérialise par une courbe course/effort, dépendant des caractéristiques du ou des premiers sous ensembles du système de contrôle 12 employés, on peut sélectionner cet effet en prévoyant des systèmes de contrôle 12 appropriés.

De préférence, lesdits moyens de verrouillage/déverrouillage 10 sont de type électromagnétique (électro-aimant à noyau plongeur, bloqueur/ventouse électromagnétique, bloqueur à liquide magnétorestrictif, ...). En particulier, la ventouse magnétique ou le bloqueur à liquide magnétorestrictif n'engendrent aucun bruit lors d'un verrouillage ou déverrouillage et ne consomment pas d'énergie au repos car ces dispositifs bloque le moyen de détection tactile 4 au repos, c'est-à-dire en position proximale, et ne comporte pas de pièce en mouvement, ce qui les rend parfaitement inaudible. Pour être plus précis, on notera que les moyens de verrouillage/déverrouillage 10 coopèrent avec le support 3 pour bloquer le mouvement du couple support 3/moyen de détection tactile 4, le support 3 étant métallique.

Par ailleurs, ladite interface homme/machine 1 comporte également des moyens pour détecter un déplacement tactile de type « glissé » engendré par un utilisateur sur le moyen de détection tactile. On comprendra qu'un déplacement tactile de type « glissé » est un déplacement rapide du doigt de l'utilisateur qui navigue dans les fonctions de l'interface, par exemple de zone de sélection en zone de sélection sans pour autant en sélectionner une plus particulièrement. Ces moyens pour détecter un déplacement tactile de type « glissé » évalue le temps de passage du doigt de l'utilisateur et détermine si ce temps dépasse un seuil signifiant que l'utilisateur souhaite sélectionner une fonction en particulier. Dans une telle situation, les moyens de verrouillage/déverrouillage 10 ne sont pas amenés dans la position déverrouillée lors de la détection d'un tel déplacement tactile de type « glissé », ne correspondant pas à une demande particulière de l'utilisateur. Par conséquent, un déverrouillage est mis en oeuvre uniquement si un utilisateur réalise un contact tactile sur une zone de sélection au delà du temps seuil, ce qui illustre une volonté réelle de l'utilisateur d'effectuer une commande d'un équipement.

Alternativement, le moyen de détection tactile 4 comporte un analyseur de force qui détermine la pression exercée par le doigt de l'utilisateur sur la zone de sélection. De manière similaire, l'analyseur de pression détermine la pression exercée par l'utilisateur et la compare à un seuil de pression. En déplaçant son doigt de manière « glissée » sur le moyen de détection tactile 4, l'utilisateur n'exerce pas une pression susceptible de dépasser le seuil de pression et les moyens de verrouillage/déverrouillage 10 ne sont pas amenés dans la position déverrouillée. En revanche, quand le seuil est dépassé, la sélection est prise en compte par le moyen de commande 5 qui déverrouille les moyens de de verrouillage/déverrouillage 10 illustrant ainsi une volonté réelle de l'utilisateur d'effectuer une commande d'un équipement.

L'interface homme/machine 1 conforme à l'invention fonctionne donc comme suit :
- lorsqu'un utilisateur décide de commander un équipement, par exemple un équipement comme la climatisation d'un véhicule automobile, il réalise un contact tactile sur le moyen de détection tactile 4 correspondant à cette commande ;
- le moyen de détection tactile 4 détecte ce contact tactile et en informe les moyens de commande 5, via la liaison électrique 6 ;
- les moyens de commande 5 envoient alors un signal de déverrouillage aux moyens de verrouillage/déverrouillage 10 qui libèrent le moyen de détection tactile 4 ;
- ce dernier se déplace alors par translation sous l'effet de l'action exercée par l'utilisateur lors du contact tactile ;
- le moyen de détection tactile 4 est soumis à la résistance du système de contrôle 12, en particulier du moyen cloquant, jusqu'à son enfoncement total, qui est détecté par ledit système 12, plus particulièrement par l'interrupteur ;
- après cette détection, les moyens de commande 5 envoient, par l'intermédiaire de la liaison électrique 7, un signal de validation correspondant à l'équipement 14 approprié, qui réalise alors la commande requise.

On comprend donc que l'invention offre un procédé de validation de la commande d'un équipement d'un véhicule automobile qui peut être résumé comme suit :
- détection d'un contact tactile sur un moyen de détection tactile 4,
- sélection d'une fonction, par exemple par maintien du contact tactile sur une zone de sélection,
- déverrouillage des moyens de verrouillage/déverrouillage 10,
- déplacement par translation du moyen de détection tactile 4,
- commutation du système de contrôle 12, avantageusement via l'interrupteur,
- transmission d'un signal commuté par le système de contrôle 12, correspondant à une validation de ladite fonction,
- activation de l'équipement 14 correspondant à ladite zone de sélection.

Dans une variante d'un tel procédé, le moyen de détection tactile 14 est associé physiquement à un dispositif d'affichage 22. Dans ce cas, le dispositif d'affichage 22 est directement placé sous le moyen de détection tactile 4, ce dernier étant transparent ce qui permet à l'utilisateur de visualiser directement la fonction ou l'équipement choisi, par exemple par surbrillance d'un symbole affiché sur le dispositif d'affichage correspondant à l'équipement. Dans une autre variante dudit procédé, le dispositif d'affichage est déporté à un autre endroit de l'habitacle du véhicule. Dans ce cas, ce dispositif d'affichage est donc distinct de l'interface homme-machine 1.

L'invention offre également une fonction dite de « réveil » d'un boîtier contrôleur d'habitacle du véhicule. En effet, ce boîtier contrôleur, et éventuellement certaines fonctions dans l'habitacle, sont désactivées ou en état de veille après une période d'inutilisation dans le but de limiter la consommation d'énergie du véhicule. Dans un tel cas, l'interface 1 est utilisé pour demander le réveil du boîtier contrôleur en activant le système de contrôle 12, c'est-à-dire en autorisant un déplacement du moyen de détection tactile 4 pour commuter le moyen de commutation du système de contrôle 12, c'est-à-dire l'interrupteur.

Sur la figure 2, on a représenté un mode de réalisation particulier d'une interface homme/machine 1 conforme à l'invention. Dans ce mode de réalisation, les dispositifs de guidage 9A comportent, comme dans l'exemple de la figure 1, des tiges de guidage 15 - de préférence une tige à chaque coin du support 3 pour des raisons d'équilibre - qui sont associées à des cylindres 16 pratiqués dans le châssis technique 30. Ces tiges de guidage 15 sont susceptibles de coulisser dans les cylindres 16 de manière à permettre une translation du support 3 sur lequel est fixé le moyen de détection tactile 4. A titre d'exemple non limitatif, la tige et le cylindre correspondant peuvent présenter une section circulaire, carré, parallélépipédique et d'une manière générale toute forme de section permettant un coulissement.

Ces tiges de guidage 15 et les cylindres 16 correspondants présentent une longueur suffisante pour que la translation s'effectue sans coincement. Pour ce faire, la longueur de coopération entre la tige de guidage 15 et le cylindre 16 correspondant correspond à une longueur de guidage qui est évaluée en fonction des dimensions du moyen de détection tactile 4 ou de son support 3. Dans le cas où le moyen de détection tactile 4 est de forme parallélépipédique rectangle, la longueur de guidage est au moins égale à 1,5 fois la grande longueur du rectangle, autrement dit 1,5 fois la longueur du moyen de détection tactile 4 ou de son support 3 quand le moyen de détection tactile est rapporté sur le support.

En outre, les moyens de verrouillage/déverrouillage 10 prennent ici la forme de ventouses magnétiques 18 qui sont également associées au support 3 et qui maintiennent le support en position proximale, c'est-à-dire verrouillé. De plus, le système de contrôle 12, plus particulièrement le moyen cloquant, agit comme un ressort grâce l'effort fournit par le dôme flexible en poussant le support 3 vers la position proximale, contre les ventouses magnétiques 18. Le support 3 est ainsi maintenu dans cette position lorsque les ventouses magnétiques 18 sont déverrouillées, en faisant passer un courant dans leurs bobinages entourant leurs aimants permanents dont une extrémité vient en contact avec une partie métallique du moyen de détection tactile 4 ou en contact avec le support 3, quand le moyen de détection tactile 4 est solidarisé sur un tel support. L'effet ressort évoqué ci-dessus évite un mouvement intempestif du moyen de détection tactile 4 qui reste donc maintenu en position proximale tant que l'utilisateur n'a pas exercé de pression sur le moyen de détection tactile.

Ce mode de réalisation particulier comporte également :
- des joints d'isolation 19 ;
- une connexion 20 du moyen de détection tactile 4 ;
- un dispositif d'affichage 22 : TFT, plasma, LCD, avantageusement rétro-éclairé ;
- un microprocesseur 23 de contrôle et un circuit intégré électronique 24 de commande, faisant partie des moyens de commande 5 ;
- un connecteur 25 vers un faisceau d'équipements extérieurs à commander ;
- un connecteur 26 du faisceau d'alimentation électrique des ventouses magnétiques 18 ; et
- un connecteur 27 du moyen de détection tactile 4 sur le circuit intégré électronique 24.

Dans cet exemple, seul le moyen de détection tactile 4 associé au support 3 sont susceptibles d'être déplacés.

De plus, dans cet exemple, l'interface homme/machine 1 est réalisée sous forme d'un boîtier qui comprend :
- un capot supérieur 28, par exemple une pièce de décoration ;
- un capot inférieur 29 ; et
- un châssis technique 30.

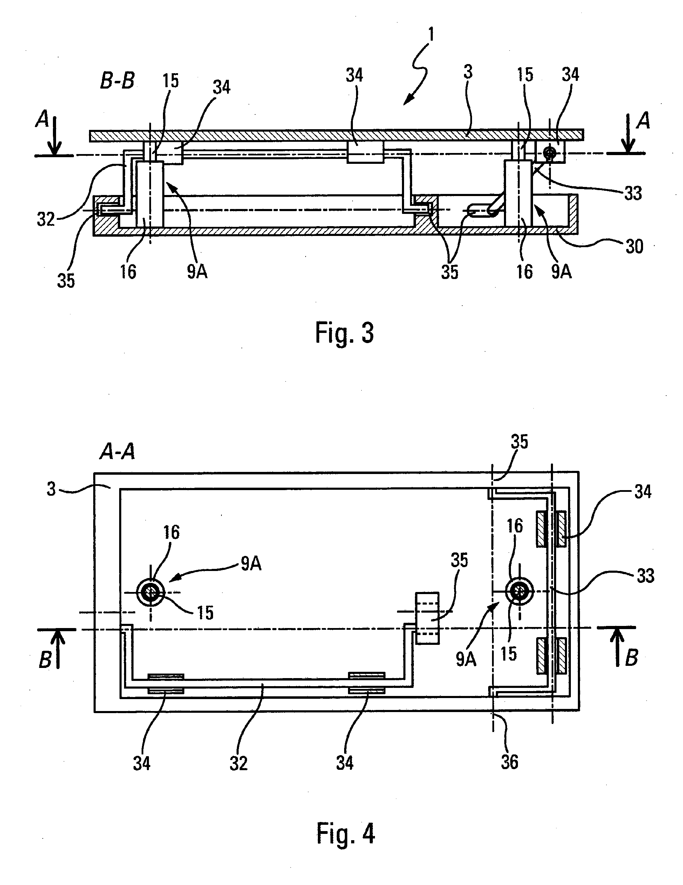

Par ailleurs, sur les figures 3 et 4, on a représenté des dispositifs de guidage 9A du type tige de guidage 15 et cylindre 16 qui dans cet exemple sont au nombre de deux. En complément de ces moyens de guidage 9A sont prévus les moyens de stabilisation 9B du guidage qui participent au déplacement du support 3 portant notamment le moyen de détection tactile 4 de l'interface 1. Ces moyen de stabilisation 9B sont ici réalisés sous forme d'un double pantographe Chaque pantographe comprend une tige articulée 32, 33 sensiblement en forme de « U ». Chaque tige 32, 33 est montée, de façon articulée, à la fois dans des points de rotation 34 solidaires du support 3 et dans des lumières 35 de forme oblong pratiquées dans des excroissances solidaires du châssis technique 30. Bien entendu, les lumières 35 peuvent être pratiquées sur le support 3 alors que les points de rotation 34 sont solidaires du châssis technique 30. Ces pantographes trouvent leur intérêt quand la longueur de guidage disponible entre la tige 15 et son cylindre 16 correspondant n'est pas suffisante. En effet, les pantographes servent à empêcher le basculement du support 3 dans les deux directions et évitent ainsi un coincement des moyens de guidage par arc-boutement. Tout particulièrement, le pantographe référencé 33 sur les figures 3 et 4 interdit un basculement du support 3 une direction correspondant à l'axe 36 passant au travers des deux lumières 35 situées sur la droite de la figure 4 alors que le pantographe référencé 32 sur les figures 3 et 4 interdit un basculement du support 3 une direction correspondant à l'axe 37 passant au travers des deux lumières 35 situées sur la gauche de la figure 4.

Ainsi, lors de son déplacement, le support 3 est maintenu parallèle par rapport au châssis technique 30 par les deux tiges articulées 32 33 qui sont agencées le long de deux côtés adjacents du support 3. On notera tout particulièrement, que la tige articulée 32 placée le long du grand côté du support 3 s'étend dans une direction perpendiculaire à la tige articulée 33 placée le long du petit côté du support 3. L'avantage d'un tel dispositif de translation réside dans le fait que quelque soit l'endroit où l'utilisateur exerce l'effort sur le moyen de détection tactile 4, tous les points du moyen de détection tactile 4 présentent un même vecteur de déplacement que le vecteur symbolisant la direction de l'effort exercé par l'utilisateur.

## Revendications

1. Interface homme/machine (1) comprenant:
- un moyen de détection tactile (4) ;
- des moyens de translation pour permettre au moyen de détection tactile (4) de se déplacer entre une position proximale et une position distale,
- le déplacement de la position proximale vers la position distale est réalisé sous l'effet d'un appui continu,
et dans laquelle est prévu un moyen de commande (5) apte à activer un équipement (14) en réponse à la détection d'un contact tactile sur une zone de sélection du moyen de détection tactile (4) ladite interface comprenant un système de contrôle (12) qui :
- engendre un effet haptique lors du déplacement du moyen de détection tactile (4) de la position proximale vers la position distale ; et
- détecte ladite position distale, cette détection étant utilisée pour valider la commande de l'équipement (14) qui a été préalablement sélectionnée par le contact tactile sur ladite zone de sélection,
et dans laquelle sont prévus des moyens de verrouillage/déverrouillage (10) susceptibles de prendre deux positions, à savoir :
- une position verrouillée de repos, dans laquelle ils empêchent le déplacement du moyen de détection tactile (4) ; et
- une position déverrouillée, dans laquelle ils autorisent ledit déplacement,
et en ce que lesdits moyens de verrouillage/déverrouillage (10) sont amenés dans ladite position déverrouillée lors de la détection du contact tactile sur ladite zone de sélection.

2. Interface homme/machine selon la revendication 1, dans laquelle les moyens de translation sont au moins un dispositif de guidage en translation (9A).

3. Interface homme/machine selon la revendication 2, dans laquelle ledit moyen de guidage en translation (9A) comporte au moins une tige (15) qui se déplace dans un cylindre (16) correspondant.

4. Interface homme/machine selon la revendication 3, dans laquelle est prévu au moins un moyen de stabilisation (9B) dudit moyen de guidage en translation (9A).

5. Interface homme/machine selon la revendication 4, dans laquelle le moyen de stabilisation (9B) comporte deux pantographes (32, 33) placés perpendiculairement l'un par rapport à l'autre.

6. Interface homme/machine selon la revendication 3, dans laquelle le système de contrôle (12) est agencé dans le prolongement de ladite tige (15).

7. Interface homme/machine selon la revendication 6, dans laquelle le système de contrôle (12) comprend un moyen cloquant agencé dans le prolongement de la tige (15), ledit moyen cloquant exerçant une force pour amener le moyen de détection tactile (4) de sa position distale vers sa position proximale.

8. Interface homme/machine selon la revendication 7, dans laquelle le système de contrôle (12) comprend un moyen de commutation agencé dans le prolongement de la tige (15) et sous le moyen cloquant.

9. Interface homme/machine selon l'une quelconque des revendications précédentes, dans laquelle lesdits moyens de verrouillage/déverrouillage (10) sont de type électromagnétique.

10. Interface homme/machine selon l'une quelconque des revendications précédentes, dans laquelle lesdits moyens de verrouillage/déverrouillage (10) sont parallèles ou perpendiculaires audit moyen de détection tactile (4).

11. Interface homme/machine selon l'une quelconque des revendications précédentes, dans laquelle est intercalé un support (3) entre le moyen de détection tactile (4) et les moyens de verrouillage/déverrouillage (10), ces derniers agissant sur le support (3).

12. Interface homme/machine selon l'une quelconque des revendications précédentes, **caractérisée en ce qu'**elle comporte un dispositif d'affichage (22) qui est installé sous le moyen de détection tactile (4) qui est transparent.

13. Procédé de validation de la commande d'un équipement (14) d'un véhicule automobile comprenant les étapes suivantes :
- on détecte un contact tactile sur un moyen de détection tactile (4),
- on sélectionne la commande de l'équipement (14) sur le moyen de détection tactile (4) par contact tactile sur une zone de sélection du moyen de détection tactile (4),
- des moyens de verrouillage/déverrouillage (10) sont déverrouillés à la détection du contact tactile sur le moyen de détection tactile (4),
- on déplace par translation le moyen de détection tactile (4) d'une position proximale vers une position distale,
- on commute un moyen de commutation quand le moyen de détection tactile (4) est en position distale,
- on active l'équipement (14) correspondant à ladite zone de sélection.

## Claims

1. Human/machine interface (1) comprising:
- a touch detection means (4);
- translation means to enable the touch detection means (4) to be displaced between a proximal position and a distal position,
- the displacement from the proximal position to the distal position is performed under the effect of a continuous pressure,
and in which is provided a control means (5) suitable for activating an equipment item (14) in response to the detection of a touch contact on a selection area of the touch detection means (4), said interface comprising a control system (12) which:
- generates a haptic effect during the displacement of the touch detection means (4) from the proximal position to the distal position;
and
- detects said distal position, this detection being used to validate the control for the equipment item (14) which has been previously selected by the touch contact on said selection area,
and in which are provided locking/unlocking means (10) capable of assuming two positions, namely:
- a locked rest position, in which they prevent the displacement of the touch detection means (4); and
- an unlocked position, in which they allow said displacement,
and in that said locking/unlocking means (10) are brought into said unlocked position upon the detection of the touch contact on said selection area.

2. Human/machine interface according to Claim 1, in which the translation means are at least one translational guiding device (9A).

3. Human/machine interface according to Claim 2, in which said translational guiding means (9A) comprises at least one rod (15) which is displaced in a corresponding cylinder (16).

4. Human/machine interface according to Claim 3, in which is provided at least one stabilization means (9B) for stabilizing said translational guiding means (9A).

5. Human/machine interface according to Claim 4, in which the stabilization means (9B) comprises two pantographs (32, 33) placed at right angles to one another.

6. Human/machine interface according to Claim 3, in which the control system (12) is arranged in the extension of said rod (15).

7. Human/machine interface according to Claim 6, in which the control system (12) comprises a blistering means arranged in the extension of the rod (15), said blistering means exerting a force to bring the touch detection means (4) from its distal position to its proximal position.

8. Human/machine interface according to Claim 7, in which the control system (12) comprises a switching means arranged in the extension of the rod (15) and under the blistering means.

9. Human/machine interface according to any one of the preceding claims, in which said locking/unlocking means (10) are of electromagnetic type.

10. Human/machine interface according to any one of the preceding claims, in which said locking/unlocking means (10) are parallel or at right angles to said touch detection means (4).

11. Human/machine interface according to any one of the preceding claims, in which is inserted a support (3) between the touch detection means (4) and the locking/unlocking means (10), the latter acting on the support (3).

12. Human/machine interface according to any one of the preceding claims, **characterized in that** it comprises a display device (22) which is installed under the touch detection means (4) which is transparent.

13. Method for validating the control for an equipment item (14) of a motor vehicle comprising the following steps:
- a touch contact is detected on a touch detection means (4),
- the control for the equipment item (14) is selected on the touch detection means (4) by touch contact on a selection area of the touch detection means (4),
- locking/unlocking means (10) are unlocked on the detection of the touch contact on the touch detection means (4),
- the touch detection means (4) is displaced by translation from a proximal position to a distal position,
- a switching means is switched when the touch detection means (4) is in the distal position,
- the equipment item (14) corresponding to said selection area is activated.

## Patentansprüche

1. Mensch-Maschine-Schnittstelle (1), die enthält:
- eine taktile Erfassungseinrichtung (4);
- Translationsverschiebungseinrichtungen, um es der taktilen Erfassungseinrichtung (4) zu ermöglichen, sich zwischen einer proximalen Stellung und einer distalen Stellung zu verschieben,
- wobei die Verschiebung von der proximalen Stellung zur distalen Stellung unter der Wirkung eines durchgehenden Drückens erfolgt,
und bei der eine Steuereinrichtung (5) vorgesehen ist, die eine Ausrüstung (14) als Reaktion auf die Erfassung eines taktilen Kontakts auf einer Auswahlzone der taktilen Erfassungseinrichtung (4) betätigen kann, wobei die Schnittstelle ein Kontrollsystem (12) enthält, das:
- bei der Verschiebung der taktilen Erfassungseinrichtung (4) von der proximalen Stellung in die distale Stellung eine haptische Wirkung erzeugt; und
- die distale Stellung erfasst, wobei diese Erfassung verwendet wird, um die Steuerung der Ausrüstung (14) zu validieren, die vorher durch den taktilen Kontakt auf der Auswahlzone ausgewählt wurde,
und bei der Verriegelungs-/ Entriegelungseinrichtungen (10) vorgesehen sind, die zwei Stellungen einnehmen können, nämlich:
- eine verriegelte Ruhestellung, in der sie die Verschiebung der taktilen Erfassungseinrichtung (4) verhindern; und
- eine entriegelte Stellung, in der sie die Verschiebung erlauben,
und dass die Verriegelungs-/ Entriegelungseinrichtungen (10) bei der Erfassung des taktilen Kontakts auf der Auswahlzone in die entriegelte Stellung gebracht werden.

2. Mensch-Maschine-Schnittstelle nach Anspruch 1, wobei die Translationsverschiebungseinrichtungen mindestens eine Translationsführungsvorrichtung (9A) sind.

3. Mensch-Maschine-Schnittstelle nach Anspruch 2, wobei die Translationsführungseinrichtung (9A) mindestens eine Stange (15) aufweist, die sich in einem entsprechenden Zylinder (16) verschiebt.

4. Mensch-Maschine-Schnittstelle nach Anspruch 3, in der mindestens eine Stabilisierungseinrichtung (9B) der Translationsführungseinrichtung (9A) vorgesehen ist.

5. Mensch-Maschine-Schnittstelle nach Anspruch 4, bei der die Stabilisierungseinrichtung (9B) zwei Pantographe (32, 33) aufweist, die lotrecht zueinander angeordnet sind.

6. Mensch-Maschine-Schnittstelle nach Anspruch 3, bei der das Kontrollsystem (12) in der Verlängerung der Stange (15) angeordnet ist.

7. Mensch-Maschine-Schnittstelle nach Anspruch 6, bei der das Kontrollsystem (12) eine blasenbildende Einrichtung enthält, die in der Verlängerung der Stange (15) angeordnet ist, wobei die blasenbildende Einrichtung eine Kraft ausübt, um die taktile Erfassungseinrichtung (4) von ihrer distalen Stellung in ihre proximale Stellung zu bringen.

8. Mensch-Maschine-Schnittstelle nach Anspruch 7, wobei das Kontrollsystem (12) eine Schalteinrichtung enthält, die in der Verlängerung der Stange (15) und unter der blasenbildenden Einrichtung angeordnet ist.

9. Mensch-Maschine-Schnittstelle nach einem der vorhergehenden Ansprüche, wobei die Verriegelungs-/ Entriegelungseinrichtungen (10) vom elektromagnetischen Typ sind.

10. Mensch-Maschine-Schnittstelle nach einem der vorhergehenden Ansprüche, wobei die Verriegelungs-/ Entriegelungseinrichtungen (10) parallel oder lotrecht zur taktilen Erfassungseinrichtung (4) sind.

11. Mensch-Maschine-Schnittstelle nach einem der vorhergehenden Ansprüche, wobei ein Träger (3) zwischen die taktile Erfassungseinrichtung (4) und die Verriegelungs-/Entriegelungseinrichtungen (10) eingeschoben ist, wobei letztere auf den Träger (3) einwirken.

12. Mensch-Maschine-Schnittstelle nach einem der vorhergehenden Ansprüche, **dadurch gekennzeichnet, dass** sie eine Anzeigevorrichtung (22) aufweist, die unter der taktilen Erfassungseinrichtung (4) angeordnet ist, die transparent ist.

13. Verfahren zur Validierung der Steuerung einer Ausrüstung (14) eines Kraftfahrzeugs, das die folgenden Schritte enthält:
- es wird ein taktiler Kontakt auf einer taktilen Erfassungseinrichtung (4) erfasst,
- die Steuerung der Ausrüstung (14) wird auf der taktilen Erfassungseinrichtung (4) durch taktilen Kontakt auf einer Auswahlzone der taktilen Erfassungseinrichtung (4) ausgewählt,
- Verriegelungs-/Entriegelungseinrichtungen (10) werden bei der Erfassung des taktilen Kontakts auf der Erfassungseinrichtung (4) entriegelt,
- die taktile Erfassungseinrichtung (4) wird durch Translationsverschiebung von einer proximalen Stellung in eine distale Stellung verschoben,
- eine Schalteinrichtung wird geschaltet, wenn die taktile Erfassungseinrichtung (4) in der distalen Stellung ist,
- die der Auswahlzone entsprechende Ausrüstung (14) wird aktiviert.
